# EUROPEAN PATENT SPECIFICATION

(11) **EP 1 888 688 B1**
(45) Date of publication and mention of the grant of the patent: **03.11.2010**
(21) Application number: 06772863.4
(22) Date of filing: 09.06.2006
(51) Int. Cl.: C08L 77/06, C08K 3/00, H01L 25/16

(54) **THERMALLY CONDUCTIVE POLYAMIDE-BASED COMPONENTS USED IN LIGHT EMITTING DIODE REFLECTOR APPLICATIONS**
WÄRMELEITFÄHIGE KOMPONENTEN AUF POLYAMIDBASIS ZUR VERWENDUNG BEI REFLEKTORANWENDUNGEN MIT LICHTEMITTIERENDEN DIODEN
COMPOSANTS THERMOCONDUCTEURS A BASE DE POLYAMIDE UTILISES DANS DES REFLECTEURS A DIODES ELECTROLUMINESCENTES

(30) Priority: 10.06.2005 US 689775 P
(43) Date of publication of application: 20.02.2008
(73) Proprietor: E.I. DU PONT DE NEMOURS AND COMPANY, Wilmington, DE 19898 (US)
(72) Inventor: MARTENS, Marvin, M., Vienna, West Virginia 26104 (US); TOPOULOS, Georgios, 1217 Meyrin (CH)
(74) Representative: Dannenberger, Oliver Andre
(86) International application number: PCT/US2006/022722
(87) International publication number: WO 2006/135840

(56) References cited:
- EP-A- 1 375 578
- EP-A- 1 466 944
- WO-A-03/085029
- WO-A-2004/036661
- US-A1- 2004 252 502
- DATABASE WPI Section Ch, Week 199543 Derwent Publications Ltd., London, GB; Class A23, AN 1995-332674 XP002398796 -& JP 07 228776 A (KURARAY CO LTD) 29 August 1995 (1995-08-29)

## Description

### Field of the Invention

The present invention relates to thermally conductive articles for use in light emitting diodes or so-called "LED's" and manufactured from polyamide resin compositions. More specifically the present invention relates to any of a variety of substrates, surfaces, housings and the like made from polyamide resin compositions and to which are affixed or secured LED's, whereby such substrates and the like offer superior heat dissipation properties.

### Background of the Invention

Because of their excellent mechanical properties, polyamide resin compositions are used in a broad range of applications such as in automotive parts, electrical and electronic parts, machine parts and the like. In many cases, because of the design flexibility they permit and their low cost, polymer resin compositions have replaced metal in these applications. However, many of these applications require that the parts be in the vicinity of or in contact with heat sources such as motors or electrical lights. And in LED's particularly, heat generated from electric current is a concern. It is therefore desirable to form these parts from materials that are sufficiently thermally conductive to dissipate the heat generated. While metal parts are thermally conductive, they are also electrically conductive, which can be undesirable in certain applications. Polyamide resin compositions are generally thermally insulating and typically electrically insulating unless they contain large amounts of electrically conductive additives. Thus, a thermally conductive, electrically insulating polyamide resin composition would be desirable and could replace metals in many applications.

In general polyamide resin compositions offer excellent fluidity during conventional molding processes, making them the material of choice for a wide spectrum of molding applications. Moreover polyamide compositions have been tailored to suit any of a number of demanding applications requiring exceptional mechanical characteristics, heat resistance, chemical resistance and/or dimensional stability when moisture is absorbed. It is not surprising then that polyamides enjoy a wide range of applications, including parts used in automobiles, electrical/electronic parts, and furniture.

As parts of electrical/electronic products, such as sealants for connectors, coil bobbins and so forth it is possible to make use of polyamide resin compositions. For these sealants, in addition to the high solder heat resistance, the parts should have a small thickness to reduce the overall weight of the parts. As nylon 66 has good fluidity, it is able to flow through the narrow gaps in the molding dies, so that thin-wall moldings can be formed. On the contrary, the solder heat resistance is poor. Moreover, nylon 6,6 shows variations in dimensions and properties as moisture is absorbed. Consequently, it is necessary to predict these variations and to take the appropriate measures in designing the parts. Because their applications are limited, and they are inappropriate for manufacturing high-precision parts. These are serious disadvantages.

Of particular interest, many materials currently available in the marketplace today do little to assist with the dissipation of heat build up common in demanding electronics applications where increasingly higher levels of power are the norm.

Accordingly, it is an object of the invention to provide articles associated with LED components (such as housings, reflectors, reflector cups, scramblers and the like) and made from specialized polyamide compositions which demonstrate superior thermal conductivity while maintaining excellent fluidity in the molding operation. A further object of the invention is to provide such a polyamide resin composition suitable for molding these components and having excellent mechanical characteristics, chemical resistance and dimensional stability upon moisture absorption. A feature of the instantly disclosed compositions is their suitability in demanding electronics applications to facilitate the dissipation of heat typically generated in components which draw significant power. Another feature of these preferred materials is that they provide thermal conductivity however without deleterious electric conductivity. It is an advantage of the invention to provide articles made from this composition which have as attributes resistance to blistering, discoloration and heat aging; and better reflectability; and further that such articles can withstand soldering operations. These and other objects, features and advantages of the present invention will become better known and understood upon having reference to the following description of the invention.

### Summary of the Invention

There is disclosed and claimed herein a thermally conductive component of a light emitting diode assembly, wherein said component comprises a polyamide resin composition comprising
(a) 15 to 70 weight percent of a semiaromatic polyamide derived from dicarboxylic acid monomers comprising 75 to 100 mole percent terephthalic acid and diamine monomers comprising 75 to 100 mole percent aliphatic diamines having 10 to 20 carbon atoms, and
(b) 30 to 85 weight percent thermally conductive material, wherein the weight percentages are based on the total weight of the composition; and wherein the thermally conductive material is selected from the group consisting of Al₂O₃, boron nitride, boron carbide, calcium fluoride, and aluminum nitride.

### Detailed Description of the Invention

Light emitting diodes are widely used in a variety of electronics applications where bright lighting is desirable. In these applications the LED is typically attached to a substrate and positioned within or along a relective surface so that its lighting characteristics are enhanced and directed in a desirable manner. LEDs have recently been the subject of renewed attention with the recent development of blue light in these applications. Inasmuch as previous applications incorporated light emitting diodes of red and green, the addition of blue light greatly expands the role and possible applications of LEDs.

However the materials used in conjunction with electronics applications typically face demanding challenges, largely due to the poor adhesive qualities of sealing materials, undesirable moisture absorption associated with conventional materials, poor thermal properties, thermal oxidation, blistering in soldering applications, and the like. Accordingly, there is disclosed and claimed herein polyamide resin compositions offering superior mechanical properties and enhanced to promote thermal conductivity and heat dissipative properties, an effective combination for use of such materials in LED applications.

The thermoplastic semiaromatic polyamide used in the present invention is one or more homopolymers, copolymers, terpolymers, or higher polymers that are derived from dicarboxylic acid monomers comprising 75 to 100 mole percent terephthalic acid and diamine monomers comprising 75 to 100 mole percent aliphatic diamines having 10 to 20 carbon atoms. It may also be a blend of more homopolymers, copolymers, terpolymers, or higher polymers that are derived from dicarboxylic acid monomers comprising 75 to 100 mole percent terephthalic acid and diamine monomers comprising 75 to 100 mole percent aliphatic diamines having 10 to 20 carbon atoms.

A further preferred aromatic dicarboxylic acid monomer is isophthalic acid.

The semiaromatic polyamide may optionally contain repeat units derived from one or more additional aliphatic dicarboxylic acid monomers or their derivatives, such as adipic acid, sebacic acid, azelaic acid, dodecanedioic acid, and other aliphatic or alicyclic dicarboxylic acid monomers having 4 to 20 carbon atoms.

As will be understood by those skilled in the art, the polyamide of this invention may be prepared from not only the dicarboxylic acids, but their corresponding carboxylic acid derivatives, which can include carboxylic acid esters, diesters, and acid chlorides, and as used herein, the term "dicarboxylic acid" refers to such derivatives as well as the dicarboxylic acids themselves.

The semiaromatic polyamide is derived from aliphatic diamines having 10 to 20 carbon atoms. Preferred aliphatic diamines may be linear or branched and include 1,10-diaminodecane; and 1,12-diaminododecane. Examples of additional diamine monomers include alicyclic diamines include 1-amino-3-aminomethyl-3,5,5,-trimethylcyclohexane; 1,4-bis(aminomethyl)cyclohexane; and bis(*p*-aminocyclohexyl)methane.

The semiaromatic polyamide may optionally contain repeat units derived from lactams and aminocarboxylic acids (or acid derivatives), such as caprolactam, 11-aminoundecanoic acid, and laurolactam.

Examples of preferred semiaromatic polyamides include poly(dodecamethylene terephthalamide) (polyamide 12,T); poly(decamethylene terephthalamide) (polyamide 10,T); and decamethylene terephthalamide/decamethylene dodecanoamide copolyamide (10,T/10,12).

Other preferred semiaromatic polyamides include one or more of polyamides derived from: terephthalic acid, isophthalic acid, and 1,10-diaminodecane; terephthalic acid, 1,10-diaminodecane, and 1,12-diaminododecane; terephthalic acid, dodecanedioic acid, and 1,10-diaminodecane; terephthalic acid, sebacic acid, and 1,10-diaminodecane; terephthalic acid, adipic acid, and 1,10-diaminodecane; terephthalic acid, dodecanedioic acid, 1,10-diaminodecane, and hexamethylenediamine; terephthalic acid, adipic acid, 1,10-diaminodecane, and hexamethylenediamine; terephthalic acid, 1,10-diaminodecane, and hexamethylenediamine; terephthalic acid, adipic acid, 1,10-diaminodecane, and dodecanedioic acid; terephthalic acid, 1,10-diaminodecane, and 11-aminoundecanoic acid; terephthalic acid, 1,10-diaminodecane, and laurolactam; terephthalic acid, 1,10-diaminodecane, and caprolactam; terephthalic acid, 1,10-diaminodecane, and 2-methyl-1,5-petanediamine; terephthalic acid, adipic acid, 1,10-diaminodecane, and 2-methyl-1,5-petanediamine; terephthalic acid, isophthalic acid, and 1,12-diaminododecane; terephthalic acid, dodecanedioic acid, and 1,12-diaminododecane; terephthalic acid, sebacic acid, and 1,12-diaminododecane; terephthalic acid, adipic acid, and 1,12-diaminododecane; terephthalic acid, dodecanedioic acid, 1,12-diaminododecane, and hexamethylenediamine; terephthalic acid, adipic acid, 1,12-diaminododecane, and hexamethylenediamine; terephthalic acid, adipic acid, and 1,12-diaminododecane; hexamethylenediamine; terephthalic acid, adipic acid, 1,12-diaminododecane, and dodecanedioic acid; terephthalic acid, 1,12-diaminododecane, and 11-aminoundecanoic acid; terephthalic acid, 1,12-diaminododecane, and laurolactam; terephthalic acid, 1,12-diaminododecane, and caprolactam; terephthalic acid, 1,12-diaminododecane, and 2-methyl-1,5-petanediamine; and terephthalic acid, adipic acid, 1,12-diaminododecane, and 2-methyl-1,5-petanediamine.

The semicrystalline polyamide will preferably have a melting point that is at least about 270 °C and more preferably at least about 280 °C and is preferably less than about 340 °C.

The polyamide resin compositions of the invention are made thermally conductive but not susceptible of conducting electrical current therewithin. The latter requirement is essential because within the current LED technologies and applications it is important that the polymer composition is a strong insulator and does not transmit electric current, so that the functionality of the LED device is not impaired. For example, many applications require in their technical specifications that low ionic content be maintained in the polymer in order to prevent any interference with an LED supply current and LED semiconductive operations. On the other hand the thermal conductivity of the polymer composition would be of great advantage, inasmuch as with the increasing power of the LEDs there is a significant need for heat evacuation. With improved cooling of the LED device a higher LED luminous output can be achieved. By "thermally conductive material" is meant materials that dissipate heat from the source of heat, such as heat from diodes in semiconductors. Such materials include those having thermal conductivity of at least about 5 watts/m K.

Accordingly, the instantly disclosed polyamide compositions are modified to provide thermal conductivity but without electric conductivity. Materials for this purpose are selected from the group consisting of Al2O3, boron nitride, boron carbide, calcium fluoride and aluminum nitride. Of these, Al2O3, boron nitride, calcium fluoride, are and boron carbide are preferred. Overall as a class these materials are incorporated in amounts ranging from 30 to 85 weight percent, preferably from 30 to 70 weight percent, and most preferably from 30 to 50 weight percent, based on the total weight of the composition.

Further, for the polyamide resin composition of this invention, inorganic fillers can be incorporated so long as they are of a type or incorporated in an amount that does not alter or modify the total composition to make it electrically conductive. Such fillers typically include glass fibers, calcium titanate, whiskers, kaolin, talc, mica, Wollastonite etc. If it is necessary to increase the mechanical strength of the molding, it is preferable to add glass fibers. If it is necessary to increase the dimensional stability of the molding and to suppress warpage, kaolin, talc, mica or glass flakes may be added.

Preferred filler types are inorganic fillers such as glass fibers and mineral fillers or mixtures thereof. The concentration of fillers in the filled composition can be selected according to the usual practice of those having skill in this field.

The compositions of the present invention can contain one or more additives known in the art, such as stabilizers, antioxidants, lubricants, flame retardants and colorants, as long as these additives do not deleteriously affect the performance of the polyamide composition. In addition, for the polyamide resin composition of the invention, as long as the characteristics of the obtained molding are not degraded, other additives, such as plasticizers, oxidation inhibitors, dyes, pigments, mold release agents, etc may be added in appropriate amounts in addition to the aforementioned polyamide, thermally conductive material, and filler.

The compositions of the invention may be prepared by blending the polyamide, conductive material, and filler and then melt compounding the blend to form the composition. Such melt compounding may be carried out in single screw extruders equipped with suitable mixing screws, but is more preferably carried out in twin screw extruders.

The polyamide can be made by methods known in the art. For example, a polyamide can be prepared by a process comprising the steps of:
(a) feeding to a reactor an aqueous salt solution of an admixture of carboxylic acid and diamine;
(b) heating the aqueous salt solution under pressure until the pressure in the reactor reaches at least about 1300 kPa, with water (in the form of steam) and other volatile matter being vented from the reactor;
(c) when the temperature of the reaction mixture has reached a temperature of at least about 270 C, preferably 280-320 C, reducing the pressure in the reactor to atmospheric pressure over a period of at least 15 minutes in a manner that avoids excessive foaming of the reaction mixture;
(d) maintaining the reaction mixture at a pressure that is not greater than about atmospheric pressure, preferably under vacuum, until the polyamide formed has reached a predetermined molecular weight; and
(e) discharging the polyamide from the reactor.

It will be understood by persons skilled in the art, that the polyamide used in the present invention can also be manufactured using solid phase polymerization, extrusion polymerization, continuous polymerization, and the like. The thermally conductive material is likewise incorporated into the polymer using any of a variety of conventional techniques as understood by the person of skill.

The compositions of the present invention may be in the form of a melt-mixed blend, wherein all of the polymeric components are well-dispersed within each other and all of the non-polymeric ingredients are homogeneously dispersed in and bound by the polymer matrix, such that the blend forms a unified whole. The blend may be obtained by combining the component materials using any melt-mixing method. The component materials may be mixed to homogeneity using a melt-mixer such as a single or twin-screw extruder, blender, kneader, Banbury mixer, etc. to give a resin composition. Part of the materials may be mixed in a melt-mixer, and the rest of the materials may then be added and further melt-mixed until homogeneous. The sequence of mixing in the manufacture of the thermally conductive polyamide resin composition of this invention may be such that individual components may be melted in one shot, or the filler and/or other components may be fed from a side feeder, and the like, as will be understood by those skilled in the art.

The composition of the present invention may be formed into articles using methods known to those skilled in the art, such as, for example, injection molding, blow molding, or extrusion. Such articles can include those for use in motor housings, lamp housings, LED housings, lamp housings in automobiles and other vehicles, and electrical and electronic housings. Examples of lamp housings in automobiles and other vehicles are front and rear lights, including headlights, tail lights, and brake lights, particularly those that use light-emitting diode (LED) lamps. LED radiators made from the present compositions are also attractive.

Other methods of production of the polyamide can be used which are well known in the art. For example, the polyamide resin(s) can be produced by condensation of equimolar amounts of saturated dicarboxylic acid with a diamine. Excess diamine can be employed to provide an excess of amine end groups in the polyamide. It is also possible to use in this invention polyamides prepared by the copolymerization or terpolymerization.

Preferably, to avoid excessive polymer degradation during compounding and injection molding, all polymer preblends and compounded blends should be pre-dried to a moisture content below about 0.05%. The ingredients are then mixed in their proper proportions in a suitable vessel such as a drum or a plastic bag. The mixture is then melt blended, preferably in a single or twin screw extruder, at a melt temperature, measured at the exit of the extruder die, preferably in the range of about 310 C to 370 C. Melt temperatures significantly above 370C, generally, should be avoided to keep degradation of the polyamide to a minimum. It will be understood by persons skilled in the art that the appropriate melt temperature can be determined easily, without undue experimentation.

For good dispersion of all components, it is preferable to use a twin screw extruder with appropriate screw design, although single screw extruders are suitable as well. Appropriate screw design can also be easily determined, without undue epxerimentation, by persons skilled in the art. Moreover for preparing the moldings of the present invention, various conventional molding methods may be adopted, such as compression molding, injection molding, blow molding and extrusion molding. Also, depending on the demand, it is possible to post process the molding to form the product.

The compositions of the present invention can be used in the manufacture of a wide variety of components associated with or incorporating LED's and using melt processing techniques. Such products are intended for use at temperatures that are higher than those typically used with other polyamide compositions. Of particular interest, the compositions of the present invention can be formed into articles incorporated into LED assemblies and where heat dissipation properties are important. These compositions find utility in end uses where retention of properties at elevated temperatures is a required attribute.

## Claims

1. A thermally conductive component of a light emitting diode assembly, wherein said component comprises a polyamide resin composition comprising
(a) 15 to 70 weight percent of a semiaromatic polyamide derived from dicarboxylic acid monomers comprising 75 to 100 mole percent terephthalic acid and diamine monomers comprising 75 to 100 mole percent aliphatic diamines having 10 to 20 carbon atoms, and
(b) 30 to 85 weight percent thermally conductive material, wherein the weight percentages are based on the total weight of the composition; and wherein the thermally conductive material is selected from the group consisting of Al₂O₃, boron nitride, boron carbide, calcium fluoride, and aluminum nitride.

2. The component of claim 1, wherein the semiaromatic polyamide is one or more of poly(dodecamethylene terephthalamide) (polyamide 12,T); poly(decamethylene terephthalamide) (polyamide 10,T); and decamethylene terephthalamide/decamethylene dodecanoamide copolyamide (10,T/10,12).

3. The component of claim 1, wherein the dicarboxylic acid monomers comprise 80 to 95 mole percent terephthalic acid.

4. The component of Claim 1 further selected from the group consisting of housings, reflectors, reflector cups, and scramblers.

5. The component of Claim 1 further comprising less than 10 weight percent of an inorganic filler.

6. The component of Claim 10 wherein said filler is selected from glass fibers and glass flakes.

7. The component of Claim 5 further comprising one or more additives.

8. The component of Claim 7 wherein said one or more additives are independently selected from the group consisting of stabilizers, antioxidants, lubricants, flame retardants and colorants.

9. The component of Claim 1 wherein said thermally conductive material is incorporated in an amount from 30 to 70 weight percent.

10. The component of Claim 1 wherein said thermally conductive material is incorporated in an amount from 30 to 50 weight percent.

## Patentansprüche

1. Wärmeleitfähige Komponente eines lichtemittierenden Diodenzusammenbaus, wobei die Komponente eine Polyamidharzzusammensetzung umfasst, die Folgendes umfasst:
(a) 15 bis 70 Gewichtsprozent eines halbaromatischen Polyamids, das von Dicarbonsäuremonomeren abgeleitet ist, die 75 bis 100 Molprozent Terephthalsäure umfassen und von Diaminmonomeren, die 75 bis 100 Molprozent aliphatische Diamine umfassen, die 10 bis 20 Kohlenstoffatome aufweisen und
(b) 30 bis 85 Gewichtsprozent wärmeleitfähiges Material, wobei die Gewichtsprozentsätze auf dem Gesamtgewicht der Zusammensetzung basieren; und wobei das wärmeleitfähige Material aus der Gruppe ausgewählt wird bestehend aus A1203, Bornitrid, Borcarbid, Calciumfluorid und Aluminiumnitrid.

2. Komponente nach Anspruch 1, wobei das halbaromatische Polyamid eines oder mehrere von Poly(dodecamethylenterephthalamid) (Polyamid 12,T); Poly(decamethylenterephthalamid) (Polyamid 10,T); und Decamethylenterephthalamid/Decamethylendodecanoamidcopolyamid (10,T/10, 12) ist.

3. Komponente nach Anspruch 1, wobei die Dicarbonsäuremonomere 80 bis 95 Molprozent Terephthalsäure umfassen.

4. Komponente nach Anspruch 1, des Weiteren ausgewählt aus der Gruppe bestehend aus Gehäusen, Rückstrahlern, Rückstrahlerfassungen und Scramblern.

5. Komponente nach Anspruch 1, des Weiteren weniger als 10 Gewichtsprozent eines anorganischen Füllstoffs umfassend.

6. Komponente nach Anspruch 10, wobei der Füllstoff aus Glasfasern und Glasflocken ausgewählt wird.

7. Komponente nach Anspruch 5, des Weiteren ein oder mehrere Zusatzmittel umfassend.

8. Komponente nach Anspruch 7, wobei das eine oder die mehreren Zusatzmittel unabhängig aus der Gruppe ausgewählt werden bestehend aus Stabilisatoren, Antioxidationsmitteln, Gleitmitteln, Flammverzögerungsmitteln und Farbmitteln.

9. Komponente nach Anspruch 1, wobei das wärmeleitfähige Material in einer Menge von 30 bis 70 Gewichtsprozent eingearbeitet wird.

10. Komponente nach Anspruch 1, wobei das wärmeleitfähige Material in einer Menge von 30 bis 50 Gewichtsprozent eingearbeitet wird.

## Revendications

1. Composant thermiquement conducteur d'un assemblage pour diode électroluminescente, dans lequel ledit composant comprend une composition de résine de polyamide comprenant
(a) 15 à 70 pour cent en poids d'un polyamide semi-aromatique dérivé de monomères de l'acide dicarboxylique comprenant 75 à 100 pour cent en mole d'acide téréphtalique et de monomères de diamine comprenant 75 à 100 pour cent en mole de diamines aliphatiques ayant 10 à 20 atomes de carbone et
(b) 30 à 85 pour cent en poids de matériau thermiquement conducteur, dans lequel les pourcentages en poids sont basés sur le poids total de la composition; et dans lequel le matériau thermiquement conducteur est choisi parmi le groupe constitué de Al2O3, du nitrure de bore, du carbure de bore, du fluorure de calcium et du nitrure d'aluminium.

2. Composant selon la revendication 1, dans lequel le polyamide semi-aromatique est un ou plusieurs parmi le poly(téréphtalamide de dodécaméthylène) (polyamide 12, T); le poly(téréphtalamide de décaméthylène) (polyamide 10, T) et le copolyamide de téréphtalamide de décaméthylène/dodécanoamide de décaméthylène (10, T/10, 12).

3. Composant selon la revendication 1, dans lequel les monomères d'acide dicarboxylique comprennent 80 à 95 pour cent en mole d'acide téréphtalique.

4. Composant selon la revendication 1, choisi en outre parmi le groupe constitué des boîtiers, des réflecteurs, des coupelles réflectrices et des embrouilleurs.

5. Composant selon la revendication 1, comprenant en outre moins de 10 pour cent en poids d'une charge minérale.

6. Composant selon la revendication 10, dans lequel ladite charge est choisie parmi les fibres de verre et les flocons de verre.

7. Composant selon la revendication 5, comprenant en outre un ou plusieurs additif(s).

8. Composant selon la revendication 7, dans lequel ledit un ou plusieurs additif(s) est(sont) indépendamment choisi(s) parmi le groupe constitué des stabilisants, des antioxydants, des lubrifiants, des agents ignifuges et des colorants.

9. Composant selon la revendication 1, dans lequel ledit matériau thermiquement conducteur est incorporé en une quantité de 30 à 70 pour cent en poids.

10. Composant selon la revendication 1, dans lequel ledit matériau thermiquement conducteur est incorporé en une quantité de 30 à 50 pour cent en poids.
